(19) Europäisches Patentamt
European Patent Office
Office européen des brevets

(11) **EP 2 959 497 B1**

(12) **FASCICULE DE BREVET EUROPEEN**

(45) Date de publication et mention de la délivrance du brevet:
**30.11.2016 Bulletin 2016/48**

(51) Int Cl.:
*H01J 37/317* (2006.01)    *B82B 3/00* (2006.01)
*B82Y 40/00* (2011.01)    *G01N 33/487* (2006.01)
*B81C 1/00* (2006.01)

(21) Numéro de dépôt: **14713165.0**

(22) Date de dépôt: **21.02.2014**

(86) Numéro de dépôt international:
**PCT/FR2014/050355**

(87) Numéro de publication internationale:
**WO 2014/128412 (28.08.2014 Gazette 2014/35)**

(54) **PROCÉDÉ DE FORMATION D'UN MOTIF DANS UN ÉCHANTILLON**

VERFAHREN ZUR HERSTELLUNG EINES MUSTERS IN EINER PROBE

METHOD OF FORMING A PATTERN IN A SAMPLE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.02.2013 FR 1351630**

(43) Date de publication de la demande:
**30.12.2015 Bulletin 2015/53**

(73) Titulaire: **Centre National de la Recherche Scientifique (C.N.R.S.) 75794 Paris Cedex 16 (FR)**

(72) Inventeurs:
• **GIERAK, Jacques**
  **F-91220 Le Plessis Pate (FR)**
• **BOURHIS, Eric**
  **F-45480 Greneville en Beauce (FR)**
• **MADOURI, Ali**
  **F-91390 Morsang sur Orge (FR)**

(74) Mandataire: **Cabinet Plasseraud 66, rue de la Chaussée d'Antin 75440 Paris Cedex 09 (FR)**

(56) Documents cités:
**EP-A2- 0 767 486    WO-A1-2007/116978
US-A1- 2007 135 013    US-A1- 2008 290 291**

• **JACQUES GIERAK: "TOPICAL REVIEW; Focused ion beam technology and ultimate applications", SEMICONDUCTOR SCIENCE AND TECHNOLOGY, IOP PUBLISHING LTD, GB, vol. 24, no. 4, 1 avril 2009 (2009-04-01), page 43001, XP020150870, ISSN: 0268-1242, DOI: 10.1088/0268-1242/24/4/043001**

**Description**

La présente invention est relative aux procédés de formation d'un motif dans un échantillon, notamment pour les nano-technologies.

FR 2 897 719 décrit un procédé pour former un trou traversant dans un échantillon. Dans un tel procédé, on envoie un faisceau d'ions focalisés vers l'échantillon avec un flux suffisant pour garantir la formation d'un trou traversant, car le faisceau d'ions va, au bout d'un certain temps traverser l'échantillon. Le flux est le nombre d'ions par unité de surface de la tâche focale, rapporté au temps.

Ce genre de procédés de gravure est particulièrement efficace pour garantir la formation de trous traversant, et notamment de dimensions transversales assez faibles (de l'ordre de la dizaine de nanomètres ou moins).

Pour former un trou de dimensions plus grandes, on peut répéter ces étapes de proche en proche (point par point) pour agrandir le trou initial, et graver la totalité du volume à enlever. On comprend toutefois aisément que pour des trous de grande taille (de dimension transversale de l'ordre du micron, par exemple), un tel procédé est trop lent et couteux. Par ailleurs, la matière pulvérisée est difficile à contrôler, et risque de se redéposer à des endroits non souhaités, où elle constitue une pollution.

Une variante peut alors consister à ne graver que la périphérie du trou à former. Ainsi, au lieu de répéter les étapes de gravure d'un trou sur toute une surface, on ne les répète que sur une ligne périphérique fermée du motif à enlever. Cette variante peut donc prendre un certain temps et, en pratique, on observe qu'il est difficile de fermer la ligne périphérique car le copeau, en train d'être découpé, va parfois se replier à l'endroit où il est encore attaché à l'échantillon, et se placer sur le trajet du faisceau d'ions, l'empêchant de compléter le parcours de la périphérie.

Il existe donc un besoin de pouvoir former des motifs de grande taille avec une source d'ions focalisés.

A cet effet, on prévoit un procédé de formation d'un motif dans un échantillon comprenant :

- on fournit un échantillon présentant une épaisseur selon une direction d'épaisseur, et des dimensions transverses dans un plan transverse normal à la direction d'épaisseur, les dimensions transverses étant au moins dix fois supérieures à l'épaisseur, et dans lequel on définit un motif à former, ledit motif étant inscrit dans une surface périphérique fermée, ladite surface périphérique définissant une zone interne présentant une surface supérieure, l'échantillon présentant un champ de contraintes mécaniques en extension, parallèlement au plan transverse,

- on génère un faisceau issu d'une source d'ions de métal liquide, et on transmet ledit faisceau en direction de l'échantillon selon la direction d'épaisseur, les ions s'implantant dans la zone interne sans traverser l'échantillon,

- on balaye ladite surface supérieure avec le faisceau d'ions jusqu'à rupture le long de la surface périphérique.

De manière surprenante, les inventeurs ont constaté que, grâce à ces dispositions, on pouvait enlever une grande quantité de matière, déjà avec une dose d'ions bien inférieure à celle nécessaire pour graver le motif en mode point par point. Par ailleurs, avec cette méthode, on s'affranchit du problème de copeau replié.

Dans des modes de réalisation préférés de l'invention, on peut éventuellement avoir recours en outre à l'une et/ou à l'autre des dispositions suivantes :

- lorsqu'on transmet, on focalise le faisceau d'ions en direction de l'échantillon ;

- les ions sont des ions métalliques, gallium, argon, silicium ou néon ;

- on transmet le faisceau avec une densité inférieure à une densité de gravure avec laquelle les ions découpent l'échantillon ;

- on déplace l'échantillon par rapport au faisceau, et on balaye une autre surface avec le faisceau d'ions jusqu'à rupture en périphérie de l'autre surface ;

- on déplace l'échantillon par rapport au faisceau, et on forme un orifice dans l'échantillon en générant un faisceau issu d'une source d'ions de métal liquide, et transmettant ledit faisceau en direction de l'échantillon selon la direction d'épaisseur, avec une densité supérieure à une densité d'implantation des ions dans l'échantillon ;

- l'orifice a des dimensions, dans le plan transverse, au moins dix fois inférieure à celles du motif ;

- une pluralité desdits motifs ont des formes convergeant vers l'orifice ;

- lorsqu'on balaye la surface supérieure, on déplace une zone d'impact du faisceau sur la surface supérieure à une vitesse au moins trois fois supérieure à celle utilisée lors de la formation de l'orifice ;

- au préalable, on calibre le faisceau en générant une pluralité de trous pendant des temps différents vers un échantillon test, et on sélectionne un temps d'irradiation en observant les différents trous sur l'échantillon test (la dose peut être estimée à partir de la formule $\text{Dose} = \dfrac{I}{q} \times \dfrac{t}{S}$ I est le courant électrique, q la charge élémentaire, t le temps et S la surface) ;

- on bouche le motif avec un feuillet, et on forme un orifice dans le feuillet en générant un faisceau issu d'une source d'ions de métal liquide, et transmettant ledit faisceau en direction de l'échantillon selon la direction d'épaisseur, avec une densité supérieure à une densité d'implantation des ions dans le feuillet ;

- on place l'échantillon entre deux réservoirs, les deux réservoirs communiquant fluidiquement entre eux à travers l'échantillon ;
- on effectue une translocation moléculaire, notamment de molécule génétique, entre les deux réservoirs à travers l'échantillon ;
- on génère un courant électrique par transport osmotique entre les deux réservoirs à travers l'échantillon.

D'autres caractéristiques et avantages de l'invention apparaîtront au cours de la description suivante d'une de ses formes de réalisation, donnée à titre d'exemple non limitatif, en regard des dessins joints.

Sur les dessins :

- la figure 1 est une vue schématique d'une installation convenant pour la mise en oeuvre de l'invention,
- la figure 1a est une vue schématique d'un échantillon,
- la figure 2 est une vue de dessus de l'échantillon en cours de traitement,
- les figures 3a et 3b sont des schémas support,
- les figures 4a et 4b sont une vue en perspective de détail d'un motif 17 pendant et après formation,
- la figure 5 est un schéma en perspective d'un échantillon portant un feuillet de graphène,
- la figure 6 est une vue en perspective schématique de l'échantillon monté entre deux réservoirs.

Sur les différentes figures, les mêmes références désignent des éléments identiques ou similaires.

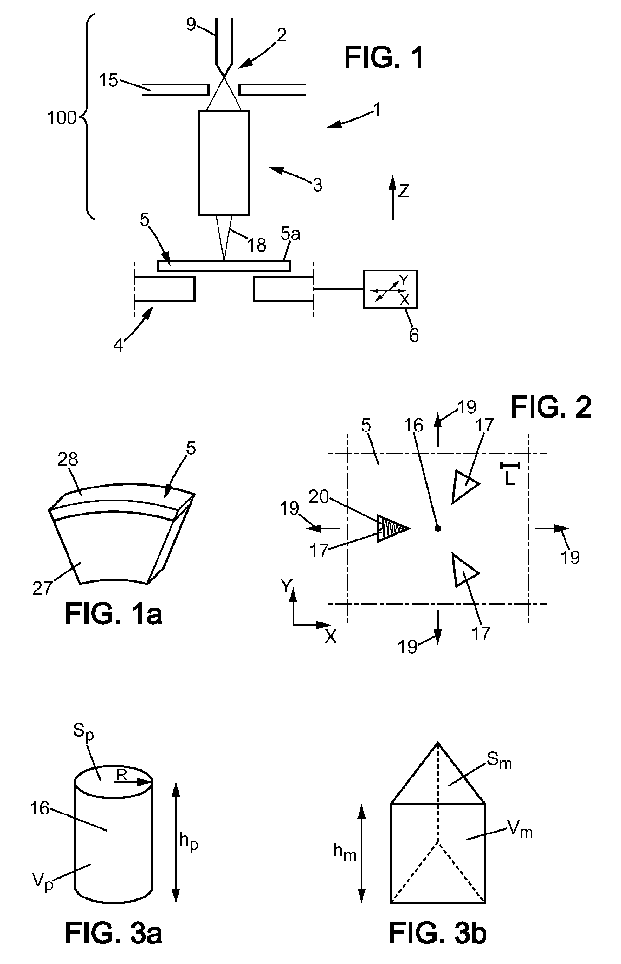

La figure 1 représente schématiquement une installation 1 d'émission d'ions. La figure 1 représente une source 2, une colonne 3 et un porte-échantillon 4 portant un échantillon 5 à former. La source 2 et la colonne 3 forment ensemble un générateur 100 de faisceau 18 d'ions. Le porte-échantillon 4 est mobile par rapport à la source par l'intermédiaire d'un système de déplacement 6 adapté pour déplacer l'échantillon selon deux directions X, Y d'un plan.

La source 2 est adaptée pour émettre des ions. Par exemple, la source 2 est réalisée sous la forme d'une source d'ions de métal liquide (LMIS, acronyme anglais de l'expression « liquid métal ion source »). D'un point de vue macroscopique, la source 2 est munie d'une enceinte dans laquelle est disposée une pointe 9. La pointe 9 peut être raccordée à une alimentation susceptible de porter la pointe à un certain potentiel électrique.

A l'extrémité ultime de la pointe 9, celle-ci comporte un noyau réalisé dans un matériau réfractaire, tels que par exemple du tungstène, et portant un revêtement. Le revêtement est constitué d'une couche continue de matériau à ioniser. Le matériau à ioniser est par exemple un métal, de l'or, ou du gallium, ou un de leurs alliages. Il s'agit par exemple d'un matériau métal à faible température de liquéfaction. On peut utiliser un matériau dont la masse est du même ordre, par exemple argon, néon, silicium, ....

La pointe 9 est également reliée à un réservoir du matériau. Le réservoir peut être adjacent à un système de chauffage comprenant un générateur et un filament électrique alimenté électriquement par le générateur et entourant le réservoir. Le filament est parcouru par un courant électrique de manière à chauffer ou liquéfier le métal contenu dans le réservoir par effet Joule. Le métal liquéfié peut s'écouler le long du noyau jusqu'à l'extrémité ultime de la pointe.

En regard de la pointe 9, il est fourni une extractrice 15 reliée à un générateur électrique, de manière à placer l'extractrice 15 à un certain potentiel électrique. La différence de potentiel entre la pointe 9 et l'extractrice 15 génère un champ électrique à l'intérieur de l'enceinte.

L'alimentation et le générateur peuvent être commandés de manière à générer un champ électrique au voisinage de l'extrémité de la pointe 9. L'application d'un champ électrique au voisinage de l'extrémité de la pointe 9 génère un écoulement du métal liquide porté par le noyau. Selon les réglages des différentes alimentations, dans des conditions de température ambiante, le métal liquide se déploie en équilibre mécanique et électrique selon un cône de Taylor. La matière est arrachée de ce cône pour former un amas métallique chargé émis en direction du porte échantillon 4.

La colonne 3 est une colonne électrostatique adaptée pour former le faisceau d'ions ou d'amas émis en direction du porte échantillon 4, et plus particulièrement de l'échantillon 5, et est notamment capable de focaliser le faisceau en une tache focale au niveau de l'échantillon, qui peut être aussi petit que quelques nanomètres.

L'échantillon est constitué d'une tranche 27 (« wafer ») de matériau portant une membrane 28 mince, c'est-à-dire dont la dimension d'épaisseur est très inférieure (au moins dix fois inférieure) aux dimensions transversales. L'épaisseur est au moins égale à, et de l'ordre de, la profondeur d'implantation des ions dans le matériau. Pour le gallium, par exemple, l'ordre de grandeur est d'un nanomètre par kilo Volt de tension accélératrice. L'échantillon est placé de manière à avoir sa direction d'épaisseur sensiblement orientée avec l'axe Z du faisceau d'ions. Ainsi, le dispositif de déplacement 6 peut déplacer l'échantillon par rapport au faisceau dans les deux dimensions transversales X et Y.

A titre d'exemple, la membrane 28 est constituée de SiN. Par ailleurs, l'épaisseur de la membrane 28 selon la direction d'épaisseur est comprise par exemple entre 10 et 200 nanomètres.

Selon un premier exemple de réalisation de procédé, au cours d'une première étape, on forme un pore 16 dans la membrane 28. Un pore 16 est une ouverture traversante formée selon la direction d'épaisseur, et comportant une dimension transversale inférieure ou de l'ordre de sa dimension selon la direction d'épaisseur. Le pore 16 a, dans l'exemple considéré, une dimension transversale de l'ordre de 5 à 50 nanomètres.

Pour réaliser ce pore, on place le générateur 100 de faisceau en configuration de gravure point par point, dans laquelle il émet des ions au niveau de l'échantillon. La colonne 3 peut de plus être utilisée pour focaliser les ions vers une région précise de l'échantillon 5.

Lors de l'émission, le faisceau a une densité (nombre d'ions par unité de surface sur la surface de l'échantillon) telle que les ions finissent par traverser l'échantillon 5. Le faisceau forme ainsi le pore 16.

Puis, on forme un orifice 17 sur une des surfaces 5a de l'échantillon. L'orifice 17 a de préférence une dimension (dans la direction transversale) très supérieure au pore 16, et présente un motif géométrique spécifique, par exemple un triangle convergeant vers le pore. La dimension transversale est par exemple de l'ordre du micron, comme représenté sur la figure 2 par l'échelle L (L=1μm). Par exemple, comme visible sur la figure 2, on utilise trois orifices 17 pointant vers la région approximative du pore 16.

Il est préférable de former les orifices 17 dans le même outil que celui utilisé pour former le pore 16. En effet, on garantit alors de maitriser les positions et orientations respectives du pore 16 et des orifices 17.

On déplace le porte échantillon 4 dans le plan X-Y de sorte à ce que le faisceau 18 arrive sensiblement au niveau de l'emplacement de l'échantillon 5 où l'orifice 17 est à former.

L'échantillon 5 est soumis à une contrainte en traction selon une ou deux directions transversales, comme illustré par les flèches 19 sur la figure 2, par exemple de l'ordre du gigaPascal (1 GPa) ou inférieure (comprise par exemple entre 100 Mégapascals (MPa) et 800 MPa). Cette traction peut par exemple être générée de manière native sur l'échantillon lors de sa fabrication.

On définit un motif à former en dessinant virtuellement une ligne périphérique 23 sur la surface supérieure 5a de l'échantillon. En théorie, une surface périphérique fermée 22 peut être définie comme le cylindre de base la ligne fermée 23 et de génératrice l'axe Z, s'étendant entre les deux faces opposées de l'échantillon. Cette surface périphérique fermée définit une zone interne 24 à enlever. La zone interne comporte une surface supérieure 25 (partie de la surface supérieure 5a de l'échantillon).

On règle le générateur 100 de faisceau d'ions pour émettre des ions présentant, au niveau de l'échantillon 5, une énergie d'implantation. C'est-à-dire que les ions émis vont être suffisamment énergétiques pour pénétrer dans le volume de l'échantillon, toutefois sans traverser celui-ci. Les ions ont par exemple une énergie de l'ordre de 30-35 keV. Au cours de l'émission, on fait en sorte que le point d'impact 26 du faisceau 18 parcoure la totalité de la surface de l'orifice 17 à former. Ceci est par exemple obtenu en déplaçant l'échantillon 5 à l'aide du dispositif de déplacement 6, selon un trajet remplissant la surface de l'orifice à former 17 sous le faisceau immobile 18. Une flèche serpentant 20 illustre un tel trajet. Lorsqu'on balaye la surface supérieure, on déplace une zone d'impact 26 du faisceau sur la surface supérieure à une vitesse au moins trois fois supérieure à celle utilisée lors de la formation de l'orifice.

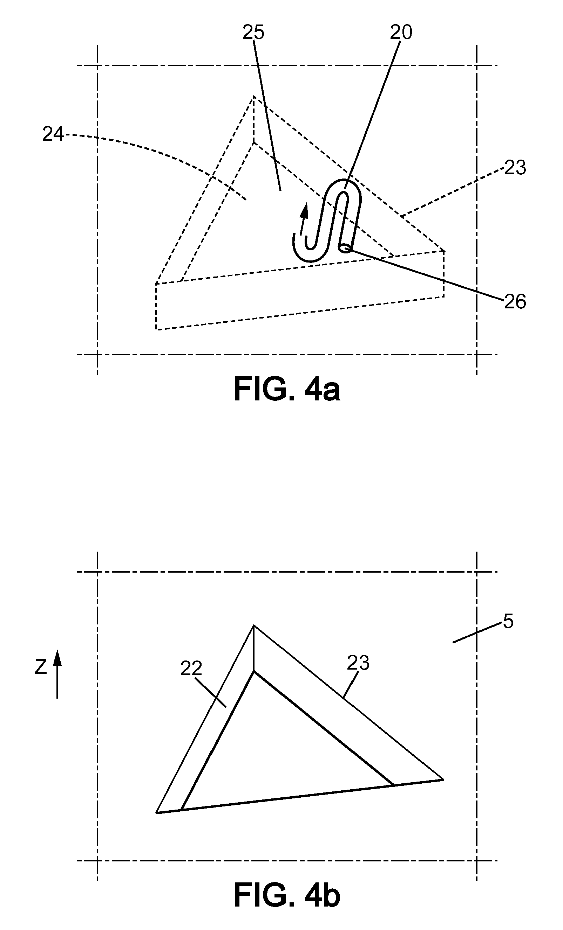

En complément, la colonne 3 peut être utilisée pour divertir le point d'impact du faisceau 18 pendant cette étape (c'est-à-dire élargir la tâche focale). Le balayage de la surface de l'orifice 17 à former peut être répété plusieurs fois jusqu'à enlèvement total de la matière, comme représenté sur la Figure 4b, où la matière enlevée a quitté l'échantillon 5. On notera qu'en pratique, la surface 22 n'est pas nécessairement définie comme un cylindre géométriquement, dépendant du matériau constitutif et de la façon dont l'irradiation est conduite.

Sans vouloir être limité par la théorie, les inventeurs ont observé qu'en balayant la surface de l'orifice à former avec un faisceau bien moins dense qu'il ne serait nécessaire pour graver la marque en mode point par point, on procédait toutefois à un enlèvement de matière de la forme du motif, net et sans copeau, à l'échelle microscopique. Les inventeurs ont observé que l'implantation répétée d'ions du faisceau dans le volume de l'échantillon générait un gonflement de celui-ci, et par conséquent un champ de contraintes compressives au niveau du motif à former. Par ailleurs, la fabrication des membranes implique des contraintes natives en extension (d'au moins 100 MPa). La conjonction du champ de contraintes compressives localisé dans le volume du motif, et du champ global de contraintes extensives fortes natives (homogènes dans le matériau à résistance mécanique (module d'Young) élevée) générées par la traction sur l'échantillon pourrait être à l'origine de la rupture localisée du matériau à l'interface entre la zone du motif et le reste de l'échantillon (à la périphérie du motif), par cisaillement brutal et localisé. Pour un matériau tel que SiN, l'implantation pourrait s'accompagner d'une transition de phase cristalline en amorphe, contribuant encore au gonflement de la structure.

Toujours sous traction, ces étapes peuvent être répétées pour former les autres orifices 17 après avoir déplacé l'échantillon par rapport au faisceau jusqu'au nouvel emplacement.

On remarquera qu'en variante, on pourrait commencer par former les orifices 17 sous traction, puis former le pore 16, le cas échéant également sous traction (mais toujours avec un temps d'irradiation plus important).

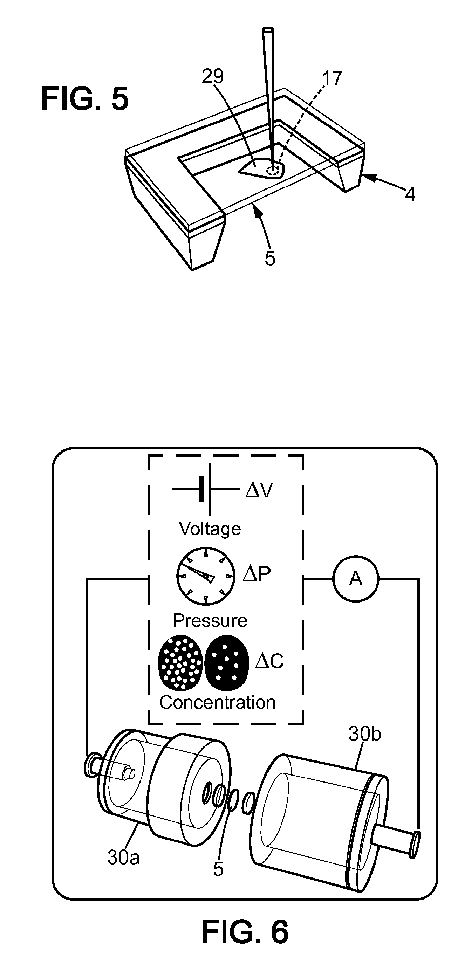

Toujours dans le cadre de cette variante, on ne forme pas nécessairement le pore 16 de manière décalée par rapport à l'orifice 17. On peut prévoir une étape intermédiaire entre la fabrication de l'orifice 17 et le perçage du pore 16, au cours de laquelle on bouche l'orifice 17. On bouche par exemple l'orifice 17 avec un feuillet de faible épaisseur par rapport à l'échantillon 5. On bouche notamment l'orifice 17 avec une structure en un matériau différent du matériau constitutif de l'échantillon 5. A titre d'exemple illustratif, comme représenté sur la figure 5, on bouche l'orifice 17 avec un feuillet 29 de graphène. Le feuillet de graphène est fabriqué et assemblé à l'échantillon 5 de toute manière appropriée connue. On perce ensuite le pore 16 dans le feuillet de graphène. Le perçage du pore 16 dans le feuillet de graphène se fait avec la même source d'ions que celle utilisée pour former l'orifice 17, ce qui permet de travailler dans le même référentiel géométrique pour la formation de l'orifice 17 et du pore 16. En fait, on bouche l'orifice d'une membrane avec une membrane. Cette dernière est d'épaisseur d'un ordre de grandeur inférieur à celle de la membrane bouchée. Ce procédé permet donc de réaliser de manière économiquement viable une structure robuste munie d'un pore de petites dimensions avec une même source d'ions.

A la place du feuillet de graphène, on peut prévoir un feuillet d'un autre matériau, par exemple nitrure de bore ou disulfure de molybdène. En variante, on prévoit un feuillet sandwich comprenant une superposition de couches élémentaires. Les couches élémentaires peuvent être des couches alternées conducteur/isolant.

Le produit ainsi fabriqué peut être utilisé dans des applications de translocation moléculaire, notamment d'ADN. On immerge le produit entre deux réservoirs de manière à ce que ces deux réservoirs communiquent fluidiquement entre eux uniquement par un ou plus pores 16.

Selon un exemple d'application, comme représenté sur la figure 6, l'échantillon 5 de nitrure de bore est placé de manière étanche entre deux réservoirs 30a et 30b. Les réservoirs 30a et 30b sont emplis de manière à prévoir un transport osmotique à travers le pore. Par exemple, les réservoirs 30a et 30b sont emplis d'une solution présentant une salinité différente dans les deux réservoirs. Cette différence de concentration génère un courant électrique entre les deux réservoirs, permettant ainsi une conversion d'énergie. Un courant électrique supérieur pourra être généré en disposant une pluralité de pores en parallèle ce qui nécessite, pour être économiquement viable, la réalisation d'un grand nombre d'orifices 17 de taille suffisante que la présente méthode permet d'obtenir.

Par ailleurs, on n'a pas forcément à mettre en oeuvre la fabrication d'un pore 16. Par exemple, on forme sur la membrane l'(es) orifice(s) 17 de grandes dimensions. On peut également remplacer le pore 16 par un nano-objet, tel qu'une structure nanométrique portée par la membrane 5.

La définition des densités de gravure et d'implantation pourra être faite au cours d'une étape de calibration préalable. Au cours de cette première étape, on génère un faisceau pendant une gamme de temps croissants en une pluralité d'emplacements d'une membrane test similaire (en matériau et épaisseur) à la membrane à former, le cas échéant sous traction. Puis, on procède à une imagerie, le cas échéant avec un dispositif distinct, pour vérifier la présence d'un trou traversant (pour les plus hautes densités), non traversant, ou l'absence de trou. Ainsi, la densité de gravure point par point est définie comme une densité à partir de laquelle la perforation est vraisemblable, et la densité d'implantation est choisie suffisamment inférieure de cette valeur seuil.

Ci-après, on estime la dose utilisée pour dessiner et irradier un orifice selon un motif triangulaire 17. L'orifice 17 est le volume interne à une surface périphérique 22 qui, dans l'exemple présenté, est estimé par un cylindre dont la base est une ligne périphérique 23 définie sur la surface supérieure (ici un triangle), et de génératrice la direction d'épaisseur entre les deux surfaces opposées le long de l'axe Z.

En émettant un courant $I_s$ de 2,8 picoAmpères (pA) pendant une durée T=33 secondes (s) en direction d'un triangle de surface 10,8 microns carrés ($\mu m^2$), la dose ionique $D_{17}$ utilisée pour dessiner cette marque est $D_{17}=(I_s*T)/q=5,78 \ 10^8$ ions, où q (q=1,6.$10^{-19}$ C) est la charge élémentaire, soit $D_{17}=5,35 \ 10^{15}$ ions/cm$^2$, où $D_{17}$ représente la charge surfacique et cm$^2$ une unité de surface en centimètres carrés.

Ci-après, on estime la dose utilisé pour former le pore 16 assimilé, sur la figure 3a à un cylindre de hauteur $h_p$ (50 nanomètres correspondant à l'épaisseur de la membrane) et de surface $S_p$ (estimée par un disque de rayon R=50 nm), et donc de volume $V_{p=}S_p*h_p$.

Le perçage est réalisé en seulement T=4,5 s, soit, pour le même courant, une dose $D_{16}=(I_s*T)/q=7,85 \ 10^7$ ions, soit $D_{16}=10^{18}$ ions/cm$^2$.

Ci-après, on estime l'épaisseur maximale que la membrane devrait avoir pour graver le motif 17 avec la dose reçue par celui-ci. Le volume gravé du pore $V_p$ est égal à 4.$10^{-16}$ cm$^3$, ce volume ayant été gravé avec 7,85.$10^7$ ions. Par conséquent, les 1,7.$10^4$ ions ayant impacté le motif triangulaire auraient enlevé par simple gravure un volume $V_M=1,7.10^4*4.10^{-16}/8.10^7=85.10^{-20}$ cm$^3$.

La hauteur du cylindre à base triangulaire de surface 10,8 microns carrés correspondante serait donc égale à 7,87.$10^{-6}$ nm. Ainsi, il est clair que le copeau n'est pas enlevé par un phénomène de gravure point par point.

## Revendications

1. Procédé de formation d'un motif dans un échantillon comprenant :

   - on fournit un échantillon (5) présentant une épaisseur selon une direction d'épaisseur (Z), et des dimensions transverses dans un plan transverse normal à la direction d'épaisseur, les dimensions transverses étant au moins dix fois supérieures à l'épaisseur, et dans lequel on définit un motif (17) à former, ledit motif étant inscrit dans une surface périphérique (22) fermée, ladite surface définissant une zone interne présentant une surface supérieure, l'échantillon présentant un champ de contraintes mécaniques en extension, parallèlement au plan transverse,

- on génère un faisceau (18) issu d'une source d'ions de métal liquide, et on transmet ledit faisceau en direction de l'échantillon (5) selon la direction d'épaisseur, les ions s'implantant dans la zone interne sans traverser l'échantillon,
- on balaye ladite surface supérieure avec le faisceau d'ions jusqu'à rupture le long de la surface périphérique.

**2.** Procédé selon la revendication 1 dans lequel lorsqu'on transmet, on focalise le faisceau d'ions en direction de l'échantillon.

**3.** Procédé selon la revendication 1 ou 2 dans lequel les ions sont des ions métalliques, gallium, argon silicium ou néon.

**4.** Procédé selon l'une des revendications 1 à 3 dans lequel on transmet le faisceau (18) avec une densité inférieure à une densité de gravure avec laquelle les ions découpent l'échantillon.

**5.** Procédé selon l'une des revendications 1 à 4, dans lequel on déplace l'échantillon (5) par rapport au faisceau, et on balaye une autre surface avec le faisceau d'ions jusqu'à rupture en périphérie de l'autre surface.

**6.** Procédé selon l'une des revendications 1 à 5, dans lequel on déplace l'échantillon (5) par rapport au faisceau, et on forme un orifice (16) dans l'échantillon en générant un faisceau issu d'une source d'ions de métal liquide, et transmettant ledit faisceau en direction de l'échantillon selon la direction d'épaisseur, avec une densité supérieure à une densité d'implantation des ions dans l'échantillon.

**7.** Procédé selon la revendication 6, dans lequel l'orifice (16) a des dimensions, dans le plan transverse, au moins dix fois inférieure à celles du motif.

**8.** Procédé selon la revendication 6 ou 7, dans lequel une pluralité desdits motifs (17) ont des formes convergeant vers l'orifice (16).

**9.** Procédé selon l'une des revendications 6 à 8, dans lequel, lorsqu'on balaye la surface supérieure, on déplace une zone d'impact (26) du faisceau sur la surface supérieure à une vitesse au moins trois fois supérieure à celle utilisée lors de la formation de l'orifice.

**10.** Procédé selon l'une des revendications 1 à 9 dans lequel, au préalable, on calibre le faisceau en générant une pluralité de trous pendant des temps différents vers un échantillon test, et on sélectionne un temps d'irradiation en observant les différents trous sur l'échantillon test.

**11.** Procédé dans lequel on met en oeuvre un procédé de formation de motif selon l'une des revendications 1 à 5 ou 10, et dans lequel on bouche le motif (17) avec un feuillet (29), et on forme un orifice (16) dans le feuillet (29) en générant un faisceau issu d'une source d'ions de métal liquide, et transmettant ledit faisceau en direction de l'échantillon selon la direction d'épaisseur, avec une densité supérieure à une densité d'implantation des ions dans le feuillet (29).

**12.** Procédé dans lequel on met en oeuvre un procédé selon l'une quelconque des revendications 1 à 11, et on place l'échantillon entre deux réservoirs, les deux réservoirs communiquant fluidiquement entre eux à travers l'échantillon (5).

**13.** Procédé selon la revendication 12, dans lequel on effectue une translocation moléculaire, notamment de molécule génétique, entre les deux réservoirs à travers l'échantillon (5).

**14.** Procédé selon la revendication 12, dans lequel on génère un courant électrique par transport osmotique entre les deux réservoirs à travers l'échantillon.

**Patentansprüche**

**1.** Verfahren zur Herstellung eines Musters in einer Probe, umfassend:

- Bereitstellen einer Probe (5), die eine Dicke entlang einer Dickenrichtung (Z) und Querabmessungen in einer Querebene senkrecht zu der Dickenrichtung aufweist, wobei die Querabmessungen mindestens zehnmal größer als die Dicke sind, und in welchem ein herzustellendes Muster (17) definiert wird, wobei das Muster in einer geschlossenen Randfläche (22) eingeschrieben ist, wobei die einen inneren Bereich definierende Fläche eine obere Fläche aufweist und die Probe einen Bereich der mechanischen Beanspruchung in Ausdehnung aufweist, parallel zur Querebene,
- Erzeugen eines Strahls (18) aus einer Flüssigmetall-Ionenquelle und Abstrahlen des Strahls in Richtung der Probe (5) entlang der Dickenrichtung, wobei sich die Ionen im inneren Bereich einlagern, ohne die Probe zu durchdringen,
- Abtasten der oberen Fläche mit dem Ionenstrahl bis zum Bruch entlang der Randfläche.

**2.** Verfahren nach Anspruch 1, wobei der Ionenstrahl beim Abstrahlen in Richtung der Probe fokussiert wird.

**3.** Verfahren nach Anspruch 1 oder 2, wobei die Ionen aus Metallionen, Gallium-, Argon-, Silizium- oder Neonionen sind.

4. Verfahren nach einem der Ansprüche 1 bis 3, wobei der Strahl (18) mit einer Dichte abgestrahlt wird, die kleiner als die Gravurdichte ist, mit der die Ionen die Probe zerschneiden.

5. Verfahren nach einem der Ansprüche 1 bis 4, wobei die Probe (5) relativ zu dem Strahl bewegt wird und eine andere Fläche mit dem Ionenstrahl bis zum Bruch am Rand der anderen Fläche abgetastet wird.

6. Verfahren nach einem der Ansprüche 1 bis 5, wobei die Probe (5) relativ zu dem Strahl bewegt wird und eine Öffnung (16) in der Probe hergestellt wird, indem ein Strahl aus einer Flüssigmetall-Ionenquelle erzeugt wird und der Strahl in Richtung der Probe entlang der Dickenrichtung abgestrahlt wird, mit einer Dichte größer einer Implantationsdichte der Ionen in der Probe.

7. Verfahren nach Anspruch 6, wobei die Öffnung (16) in der Querebene Abmessungen aufweist, die mindestens zehnmal kleiner als die des Musters sind.

8. Verfahren nach Anspruch 6 oder 7, wobei eine Vielzahl dieser Muster (17) Formen aufweist, die in Richtung der Öffnung (16) konvergieren.

9. Verfahren nach einem der Ansprüche 6 bis 8, wobei beim Abtasten der oberen Fläche ein Aufprallbereich (26) des Strahls auf der oberen Fläche mit einer Geschwindigkeit bewegt wird, die mindestens dreimal höher als die zur Herstellung der Öffnung verwendete ist.

10. Verfahren nach einem der Ansprüche 1 bis 9, wobei zunächst der Strahl kalibriert wird, indem eine Vielzahl von Löchern zu verschiedenen Zeiten bei einer Testprobe erzeugt wird und eine Bestrahlungszeit durch Beobachten der verschiedenen Löcher auf der Testprobe gewählt wird.

11. Verfahren, bei dem ein Verfahren zur Herstellung eines Musters nach einem der Ansprüche 1 bis 5 oder 10 umgesetzt wird und bei dem das Muster (17) mit einem Blatt (29) abgedeckt wird und eine Öffnung (16) in dem Blatt (29) hergestellt wird, indem ein Strahl aus einer Flüssigmetall-Ionenquelle erzeugt wird und der Strahl in Richtung der Probe entlang der Dickenrichtung abgestrahlt wird, mit einer Dichte größer einer Implantationsdichte der Ionen in dem Blatt (29).

12. Verfahren, bei dem ein Verfahren nach einem der Ansprüche 1 bis 11 umgesetzt wird und die Probe zwischen zwei Behälter platziert wird, wobei die beiden Behälter durch die Probe (5) hindurch fluidisch miteinander in Verbindung stehen.

13. Verfahren nach Anspruch 12, wobei eine molekulare Translokation, insbesondere von genetischen Molekülen, zwischen den beiden Behältern durch die Probe (5) hindurch durchgeführt wird.

14. Verfahren nach Anspruch 12, wobei ein elektrischer Strom durch den osmotischen Transport zwischen den beiden Behältern durch die Probe hindurch erzeugt wird.

**Claims**

1. Method of forming a pattern in a sample, comprising:

   - the providing of a sample (5) having a thickness in a thickness direction (Z), and transverse dimensions in a transverse plane normal to the thickness direction, the transverse dimensions being at least ten times greater than the thickness, and in which a pattern (17) to be formed is defined, said pattern being etched in a closed peripheral surface (22), said surface defining an inner region having an upper surface, the sample exhibiting a field of extensile mechanical stresses, parallel to the transverse plane,
   - the generation of a beam (18) issuing from a source of liquid metal ions, and the transmission of said beam in the direction of the sample (5) along the thickness direction (5), the ions being implanted in the inner region without passing through the sample,
   - the sweeping of said upper surface with the ion beam until breakage occurs along the peripheral surface.

2. Method according to claim 1, wherein, when transmitting, the ion beam is focused in the direction of the sample.

3. Method according to claim 1 or 2, wherein the ions are ions of metal, gallium, silicon argon or neon.

4. Method according to one of claims 1 to 3, wherein the beam is transmitted (18) at a density lower than an etching density at which the ions pass through the sample.

5. Method according to one of claims 1 to 4, wherein the sample is moved (5) relative to the beam, and another surface is swept with the ion beam until breakage occurs at the periphery of the other surface.

6. Method according to one of claims 1 to 5, wherein the sample is moved (5) relative to the beam, and an aperture (16) is formed in the sample by generating a beam issuing from a source of liquid metal ions, and transmitting said beam in the direction of the sample along the thickness direction, at a density greater than a density of ion implantation in the sample.

7. Method according to claim 6, wherein the aperture (16) has dimensions, in the transverse plane, that are at least ten times smaller than those of the pattern.

8. Method according to claim 6 or 7, wherein a plurality of said patterns (17) have shapes that converge toward the aperture (16).

9. Method according to one of claims 6 to 8, wherein, when sweeping the upper surface, an area of impact (26) of the beam on the upper surface is moved at a rate at least three times greater than that used during formation of the aperture.

10. Method according to one of claims 1 to 9, wherein the beam is calibrated beforehand by generating a plurality of holes during different times in a test sample, and an irradiation time is selected by observing the various holes in the test sample.

11. Method wherein use is made of a method of forming a pattern according to one of claims 1 to 5 or 10, and wherein the pattern (17) is plugged with a sheet (29), and an aperture (16) is formed in the sheet (29) by generating a beam issuing from a source of liquid metal ions, and transmitting said beam in the direction of the sample along the thickness direction, with a density greater than a density of ion implantation in the sheet (29).

12. Method wherein use is made of a method according to any one of claims 1 to 11, and the sample is placed between two reservoirs, the two reservoirs having fluid communication between them through the sample (5).

13. Method according to claim 12, wherein a molecular translocation is carried out, in particular of a gene molecule, between the two reservoirs through the sample (5).

14. Method according to claim 12, wherein an electric current is generated by osmotic transport between the two reservoirs, through the sample.

FIG. 1

FIG. 2

FIG. 1a

FIG. 3a

FIG. 3b

**FIG. 4a**

**FIG. 4b**

FIG. 5

FIG. 6

**RÉFÉRENCES CITÉES DANS LA DESCRIPTION**

**Documents brevets cités dans la description**

- FR 2897719